# EUROPEAN PATENT APPLICATION

(11) **EP 2 418 495 A1**
(43) Date of publication of application: **15.02.2012**
(21) Application number: 10758925.1
(22) Date of filing: 05.04.2010
(51) Int. Cl.: G01R 1/067, C25D 7/00, F16F 1/02, G01R 1/073, G01R 31/26, H01R 13/24

(54) **SPRING WIRE, CONTACT PROBE, AND PROBE UNIT**

(30) Priority: 03.04.2009 JP 2009091371
(71) Applicant: NHK Spring Co., Ltd., Yokohama-shi, Kanagawa 236-0004 (JP)
(72) Inventor: KAZAMA, Toshio, Kamiina-gun Nagano 399-4301 (JP); ISHIKAWA, Shigeki, Kamiina-gun Nagano 399-4301 (JP)
(74) Representative: HOFFMANN EITLE
(86) International application number: PCT/JP2010/056182
(87) International publication number: WO 2010/114164

(57) **Abstract**

Provided herein are a spring wire rod that can ensure conductivity capable of dealing with a high-frequency signal having a frequency of equal to or higher than 1 GHz while ensuring a spring characteristic, a contact probe using the spring wire rod, and a probe unit using the contact probe. The spring wire rod includes a wire core that is made of a conductive material having an electrical resistivity of equal to or slower than 5.00 × 10⁻⁸ Ω•m, and a coating member 3 that is made of a spring material having a longitudinal elastic modulus of equal to or higher than 1.00 × 10⁴ kgf/mm² and coats an outer circumference of the core. A coating thickness d of the coating member is smaller than a minimum value r of a distance between the center of gravity of a transverse cross section of the core and the outer edge of the transverse cross section.

## Description

### Field

The present invention relates to a spring wire rod, a contact probe formed by using the spring wire rod, and a probe unit that includes the contact probe. Background

Conventionally, a pin probe obtained by connecting two conductive contact portions provided at both ends to each other by a coil spring has been known as a contact probe used for testing electric characteristics of a semiconductor package and the like (see, Patent Literature 1, for example). As a spring material forming the coil spring, a single material such as copper alloy and noble metal alloy is often used. These materials have preferable spring characteristics. However, there is a problem that these materials have high electrical resistivities. In order to solve the problem and lower an electrical resistivity of the coil spring, a technique of plating metal having a low electrical resistivity and a high conductivity, such as gold, on a surface of a spring material has been known (see, Patent Literature 2, for example). Furthermore, a technique of further plating on an outer circumference of a tightly wound portion after coiling the plated spring material has been known (see, Patent Literature 3, for example).

### Citation List

Patent Literature 1: Japanese Patent Application Laid-open No. 2005-345235
Patent Literature 2: Japanese Patent Application Laid-open No. 2008-25833
Patent Literature 3: Japanese Patent Application Laid-open No. 2004-309490

### Summary

### Technical problem

In recent years, a high-frequency signal having a frequency of equal to or higher than 1 GHz is used as a signal output to a semiconductor package or the like. In order to realize a contact probe capable of testing electric characteristics using such a high-frequency signal, it is required to ensure high conductivity while lowering the resistivity and the inductance of a coil spring. In the cases of the above-mentioned conventional techniques, it can be considered that the thickness of a plated costing is made larger for lowering the resistivity and the inductance of the coil spring. However, the thickness of the plated coating is limited (to approximately 3 µm). Therefore, it has been difficult to ensure conductivity capable of dealing with the high-frequency signal simply by making the plated coating thicker.

The present invention has been made in view of the above-described circumstances and an object of the invention is to provide a spring wire rod that can ensure conductivity capable of dealing with a high-frequency signal having a frequency of equal to or higher than 1 GHz while ensuring a spring characteristic, a contact probe using the spring wire rod, and a probe unit using the contact probe.

### Solution to Problem

In order to solve the problem described above and achieve the object, a spring wire rod according to the present invention includes: a wire core that is made of a conductive material having an electrical resistivity of equal to or lower than 5.00 × 10⁻⁸ Ω•m; and a coating member that is made of a spring material having a longitudinal elastic modulus of equal to or higher than 1.00 × 10⁴ kgf/mm² and coats an outer circumference of the core.

In the spring wire rod according to the present invention as set forth in the invention described above, a coating thickness of the coating member is smaller than a minimum value of a distance between a center of gravity of a transverse cross section of the core and an outer edge of the transverse cross section.

In the spring wire rod according to the present invention as set forth in the invention described above, a plated coating that coats an outer circumference of the coating member is further included.

A contact probe according to the present invention includes: a first plunger and a second plunger each of which has an axisymmetric shape and is made of a conductive material; and a compression coil spring of which both ends in a lengthwise direction are press fitted onto respective ends of the first plunger and the second plunger, the respective ends being opposed to each other, the compression coil spring being extensible in the lengthwise direction, wherein the compression coil spring is formed by winding the spring wire rod according to the present invention as set forth at a predetermined pitch.

A probe unit according to the present invention includes: a plurality of contact probes each of which has a first plunger and a second plunger each of which has an axisymmetric shape and is made of a conductive material, and a compression coil spring of which both ends in a lengthwise direction are press fitted onto respective ends of the first plunger and the second plunger, the respective ends being opposed to each other, the compression coil spring being extensible in the lengthwise direction; and a plate-like probe holder having a plurality of holding holes that hold the contact probes such that the contact probes are extensible in a state where both ends of each contact probe are exposed from opposite plate faces, wherein each compression coil spring is formed by winding the spring wire rod according to the present invention as set forth at a predetermined pitch.

In the probe unit according to the present invention as set forth in the invention described above, the probe holder includes a base material that is made of a conductive material and an insulating coating that coats a surface of the base material.

### Advantageous Effects of Invention

According to the invention, a spring wire rod includes a wire core that is made of a conductive material having an electrical resistivity of equal to or lower than 5.00 × 10⁻⁸ Ω•m and a coating member that is made of a spring material having a longitudinal elastic modulus of equal to or higher than 1.00 × 10⁴ kgf/mm² and coats an outer circumference of the core. Therefore, conductivity and a spring characteristic can be balanced preferably. Accordingly, the spring wire rod can ensure the conductivity capable of dealing with a high-frequency signal having a frequency of equal to or higher than 1 GHz while ensuring the spring characteristic.

### Brief Description of Drawings

FIG. 1 is a transverse cross-sectional view illustrating a configuration of a spring wire rod according to one embodiment of the invention.
FIG. 2 is a perspective view illustrating a configuration of a probe unit according to one embodiment of the invention.
FIG. 3 is a partial cross-sectional view illustrating a configuration of main parts of the probe unit according to the embodiment of the invention.
FIG. 4 is a transverse cross-sectional view illustrating a configuration of a spring wire rod according to a first modification of the embodiment of the invention.
FIG. 5 is a transverse cross-sectional view illustrating a configuration of a spring wire rod according to a second modification of the embodiment of the invention.
FIG. 6 is a transverse cross-sectional view illustrating a configuration of a spring wire rod according to a third modification of the embodiment of the invention.
FIG. 7 is a transverse cross-sectional view illustrating a configuration of a spring wire rod according to a fourth modification of the embodiment of the invention.
FIG. 8 is a view illustrating a configuration of a connection terminal as another application example of the spring wire rod according to the embodiment of the invention.

### Description of Embodiments

Hereinafter, embodiments of the invention are described with reference to the accompanying drawings. The drawings are schematically illustrated. Therefore, it should be noted that a relationship between the thickness and the width of each part and a ratio of the thickness of each part are different from practical ones in some case.
It is needless to say that parts of which relationships and ratios of dimensions are different among the drawings are included.

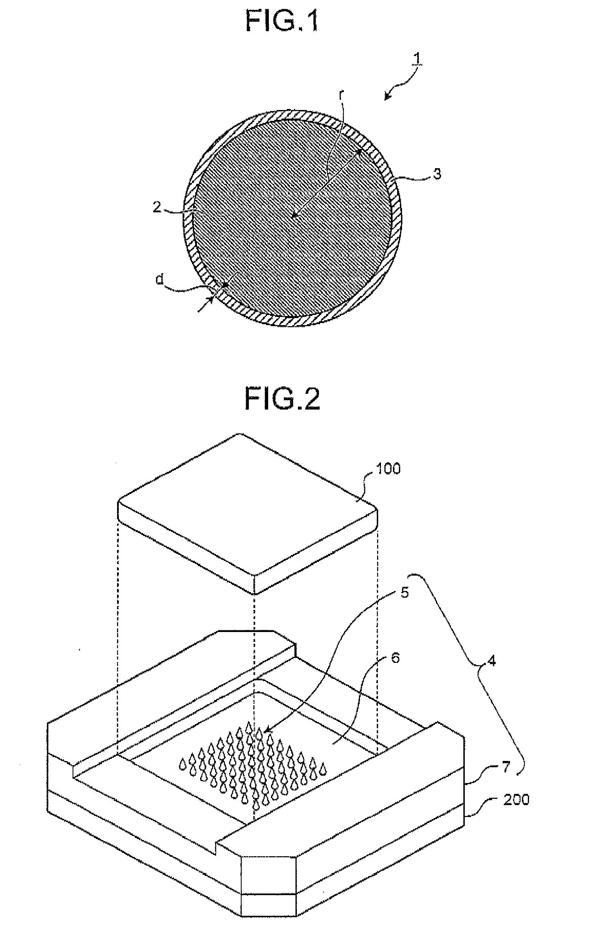

FIG. 1 is a transverse cross-sectional view illustrating a configuration of a spring wire rod according to one embodiment of the invention. A spring wire rod 1 in FIG. 1 includes a wire core 2 and a coating member 3. The wire core 2 is made of a conductive material having an electrical resistivity of equal to or lower than 5.00 × 10^{- 8} Ω•m. The coating member 3 is made of a spring material having a longitudinal elastic modulus of equal to or higher than 1.00 × 10⁴ kgf/mm² and coats an outer circumference of the core 2.

The core 2 has a circular transverse cross section and is realized by using any one of materials such as gold, gold alloy, copper, copper alloy, aluminum, beryllium copper, beryllium nickel, and silver alloy.

The coating member 3 is realized by using any one of materials such as spring steel, stainless steel, beryllium copper, a hard steel wire, and phosphor bronze.
A coating thickness d of the coating member 3 is smaller than a radius r (a minimum value of a distance between the center of gravity of the transverse cross section (center of circle) and the outer edge of the transverse cross section) of a circle forming the transverse cross section of the core 2.

The spring wire rod 1 having the above-mentioned configuration is formed by subjecting an integrated structure, which, is obtained by inserting the core 2 into a hollow portion of a pipe-like member made of a material that is the same as that of the coating member 3, to wire drawing processing or drawing processing, for example. Incidentally, the spring wire rod 1 may be formed by subjecting an integrated structure, in which the coating member 3 coats the core 2 by rolling up a clad member made of a conductive material forming the core 2 and a spring material forming the coating member 3, to the drawing processing.

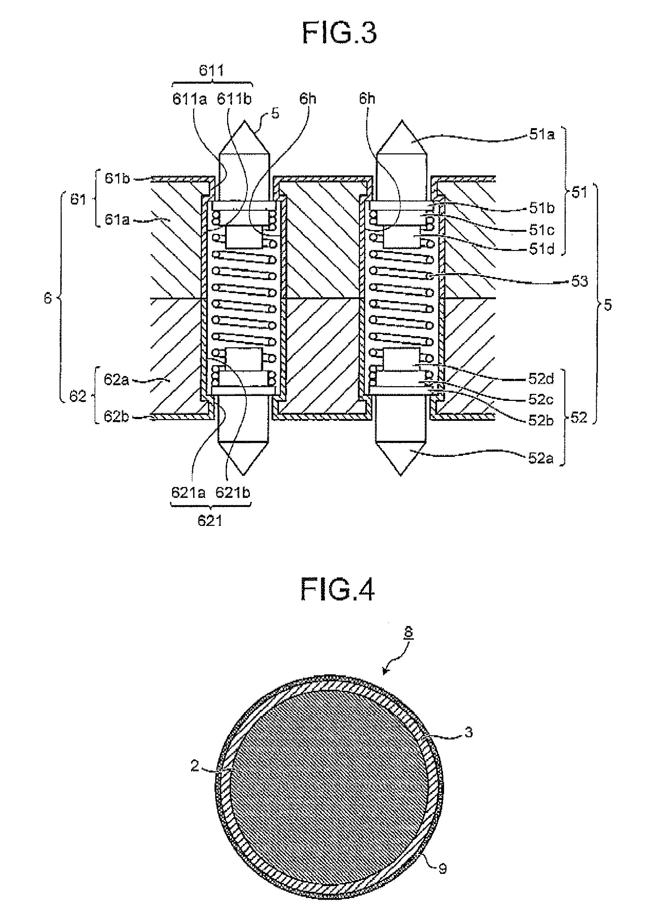

FIG. 2 is a perspective view illustrating a configuration of a probe unit that includes a contact probe realized by using the spring wire rod 1. FIG. 3 is a partial cross-sectional view illustrating a configuration. of main parts of the probe unit illustrated in FIG. 2. A probe unit 4 as illustrated in FIGS. 2 and 3 is a device (test socket) for connecting a semiconductor package 100 to be tested and a wiring substrate 200 at a tester side that outputs a test signal to the semiconductor package 100. To be more specific, the probe unit 4 includes a plurality of contact probes 5, a probe holder 6, and a base member 7. The contact probes 5 make contact with the electrodes of the semiconductor package 100 and the wiring substrate 200 at both ends of the contact probes 5 in the lengthwise direction. The semiconductor package 100 and the wiring substrate 200 are two members to be contacted, which are different from each other. The probe holder 6 holds the plurality of contact probes 5. The base member 7 is arranged so as to surround an outer circumference of the probe holder 6, fixes and holds the probe holder 6, and suppresses positional deviation of the semiconductor package 100 that is brought into contact with the probe holder 6.

The contact probe 5 has a first plunger 51, a second plunger 52, and a compression coil spring 53. Each of the first plunger 51 and the second plunger 52 is made of a conductive material and has an axisymmetric shape. The compression coil spring 53 is formed by winding the spring wire rod 1 at a predetermined pitch and both ends of the compression coil spring 53 in the lengthwise direction are press fitted onto the respective ends of the first plunger 51 and the second plunger 52, the respective ends being opposed to each other. Furthermore, the compression coil spring 53 is extensible in the lengthwise direction. When the semiconductor package 100 is tested, the first plunger 51 is brought into contact with the semiconductor package 100 and the second plunger 52 is brought into contact with the wiring substrate 200.

The first plunger 51 has a front end portion 51a having a sharpened tip, a flange portion 51b, a boss portion 51c, and a base end portion 51d. The flange portion 51b has a diameter that is larger than the diameter of the front end portion 51a. The boss portion 51c projects in the direction opposite to the front end portion 51a from the flange portion 51b, and forms a cylindrical shape having a diameter that is smaller than the diameter of the flange portion 51b and is slightly larger than the inner diameter of the compression coil spring 53. One end of the compression, coil spring 53 is press fitted onto the boss portion 51c. The base end portion 51d projects to the side opposite to the flange portion 51b from the boss portion 51c, and forms a cylindrical shape having a diameter that is smaller than the diameter of the boss portion 51c and is smaller than the inner diameter of the compression coil spring 53. The first plunger 51 has an axisymmetric shape with respect to a center axis thereof in the lengthwise direction.

The second plunger 52 has the same shape as that of the first plunger 51. The second plunger 52 has a front end portion 52a, a flange portion 52b, a boss portion 52c, and a base end portion 52d. Incidentally, the second plunger may have a shape that is different from that of the first plunger 51.

The compression coil spring 53 is formed by winding the spring wire rod 1 at a constant pitch. However, in the present embodiment, a compression coil spring formed by winding the spring wire rod 1 at an irregular pitch of two stages, including a tightly wound portion and a loosely wound portion, can be applied.

The probe holder 6 is formed by placing a first substrate 61 and a second substrate 62 on one another in a plate thickness direction. Furthermore, the probe holder 6 has a plurality of holding holes 6h through which the contact probes 5 are inserted and that hold the contact probes 5. An arrangement pattern of the plurality of holding holes 6h is defined so as to correspond to an arrangement pattern of electrodes of the semiconductor package 100.

A plurality of holes 611 are provided on the first substrate 61. Each hole 611 includes a small diameter hole 611a and a large diameter hole 611b. The front end portion 51a of each first plunger 51 can be inserted through the small diameter hole 611a. The large diameter hole 611b has the same axis of the small diameter hole 611a and has a diameter that is larger than that of the small diameter hole 611a. The small diameter hole 611a has the diameter that is smaller than that of the flange portion 51b so as to prevent the first plunger 51 from coming off. The first substrate 61 includes a base material 61a made of metal and an insulating coating 61b. The insulating coating 61b is made of resin and the like, coating a surface of the base material 61a excluding a surface opposed to the second substrate 62.

A plurality of holes 621 that correspond to the plurality of respective holes 611 provided on the first substrate 61 are provided on the second substrate 62. The holes 621 form the holding holes 6h together with the holes 611 communicating with the holes 621. Each hole 621 has a small diameter hole 621a and a large diameter hole 621b. The front end portion 52a of each second plunger 52 can be inserted through the small diameter hole 621a. The large diameter hole 621b has the same axis of the small diameter hole 621a and a diameter that is larger than that of the small diameter hole 621a. The small diameter hole 621a has the diameter that is smaller than that of the flange portion 52b so as to prevent the second plunger 52 from coming off. The second substrate 62 includes a base material 62a made of a conductive material and an insulating coating 62b. The insulating coating 62b is made of resin and the like, costing a surface of the base material 62a excluding a surface opposed to the first substrate 61.

With the probe holder 6 having the above-mentioned configuration, strengths of the holding holes 6h can be improved by using metals as the base materials 61a, 62a. Furthermore, with the probe holder 6, thermal deformation and warpage deformation due to increase in load when the number of contact probes 5 held by the probe holder 6 is large (for example, approximately 1000) can be suppressed. In addition, with the probe holder 6, the base materials 61a, 62a form a strong earth ground. Therefore, an electromagnetic shield effect is obtained and cross talk of test signals is suppressed so as to improve electric characteristics of the probe unit 4.

Although the first substrate 61 and the second substrate 62 form a symmetric shape in the vertical direction in FIG. 3, the plate thicknesses of the first substrate and the second substrate may be different from each other.

Here an outline of a method of processing the first substrate 61 and the second substrate 62 is described-Since the processing methods are the same between the first substrate 61 and the second substrate 62, description is made by taking the first substrate 61 as an example. When the first substrate 61 is processed, at first, through-holes each having a predetermined diameter are formed with the base material 61a at positions at which the holes 611 are formed by laser processing, drilling processing, or the like. Subsequently, resin in a liquid form that is a material of the insulating coating 62b is flown into a predetermined mold into which the base material 61a has been put so as to be cured. With this, the resin coats the surrounding of the base material 61a and fill inner portions of the through-holes. Thereafter, hole opening processing is performed on the resin portions filled into the through-holes so as to form the holes 611. Finally, a. surface to be opposed to the semiconductor package 100 is planarly cut while the insulating coating 62b is left. On the other hand, a surface to be opposed to the second substrate 62 is planarly cut so as to expose the base material 61a. With this, the first substrate 61 is formed.

According to the method of processing the first substrate 61, flatness processing by planar cutting is performed after the insulating coating 61b has been formed. Therefore, an acceptable range of dimension accuracy of the base material 61a is made large so that a processing time of the first substrate 61 can be largely shortened.

It is to be noted that powdery ceramic, or a mixture of resin and ceramic may be applied as the material of the insulating coating 61b. Heat and/or pressure are/is applied to the material of the insulating coating 61b so as to cure the material on the surface of the base material 61a.

According to one embodiment of the invention as described above, the spring wire rod 1 includes the wire core 2 that is made of a conductive material having an electrical resistivity of equal to or lower than 5.00 × 10⁻⁸ Ω•m and the coating member 3 that is made of a spring material having a longitudinal elastic modulus of equal to or higher than 1.00 × 10⁴ kgf/mm² and coats an outer circumference of the core 2. Thexefore, the conductivity and the spring characteristic can be balanced preferably, Accordingly, the spring wire rod 1 can ensure the conductivity capable of dealing with a high-frequency signal having a frequency of equal to or higher than 1 GHz while ensuring the spring characteristic.

Furthermore, according to the embodiment, since the conductivity and the spring characteristic are balanced preferably as described above, even if the winding number of the compression coil spring 53 is reduced to lower the inductance, the spring characteristic is not significantly deteriorated. Accordingly, the contact probes 5 can be shortened so as to realize the thin probe unit 4. In particular, in the embodiment, since the base material of the probe holder 6 is metal, there can be provided the probe unit 4 with no problem in strength even if the probe unit 4 is made thinner.

Furthermore, according to the embodiment, since the coating member 3 coats the entire outer circumference of the core 2, anisotropy is not generated on the spring characteristic unlike a case in which a contact probe is formed by sandwiching a core between coating members as disclosed in Japanese Patent Application Laid-open No. 2006-284292. Accordingly, the spring wire rod 1 according to the embodiment can be easily applied to various applications.

FIG. 4 is a transverse cross-sectional view illustrating a configuration of a spring wire rod according to a first modification of the embodiment. A spring wire rod 8 as illustrated in FIG. 4 has a plated coating 9 on an outer circumferential surface of the coating member 3 in addition to the configuration of the spring wire rod 1. The plated coating 9 is made of metal such as gold, goldtin alloy or palladium. With the spring wire rod 8 having such a configuration the conductivity capable of dealing with a high-frequency signal can be ensured without making the plated coating 9 thicker to the limit.

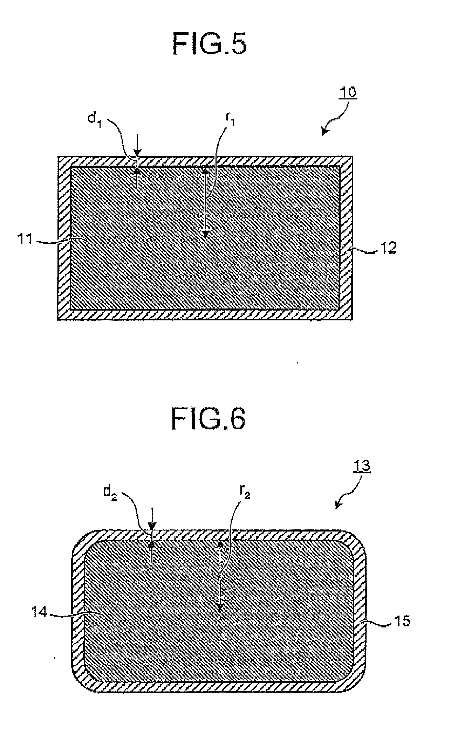

FIG- 5 is a transverse cross-sectional view illustrating a configuration of a spring wire rod according to a second modification, of the embodiment. A spring wire rod 10 as illustrated in FIG. 5 has a wire core 11 and a coating member 12. The core 11 is made of a material that is the same as that of the core 2. The coating member 12 is made of a material that is the same as that of the coating member 3 and coats an outer circumference of the core 11. The spring wire rod 10 has a transverse cross section having a rectangular shape. A thickness d₁ of the coating member 12 is smaller than a minimum value r₁ of a distance between the center of gravity of the transverse cross section of the core 11 and the outer edge thereof.

FIG. 6 is a transverse cross-sectional view illustrating a configuration of a spring wire rod according to a third modification of the embodiment. A spring wire rod 13 as illustrated in FIG. 6 has a wire core 14 and a coating member 15. The core 14 is made of a material that is the same as that of the core 2. The coating member 15 is made of a material that is the same as that of the coating member 3 and coats an outer circumference of the core 14. The spring wire rod 13 has a transverse cross section having a substantially rectangular shape that is round chamfered. A thickness d₂ of the coating member 15 is smaller than a minimum value r₂ of a distance between the center of gravity of the transverse cross section of the core 14 and the outer edge thereof.

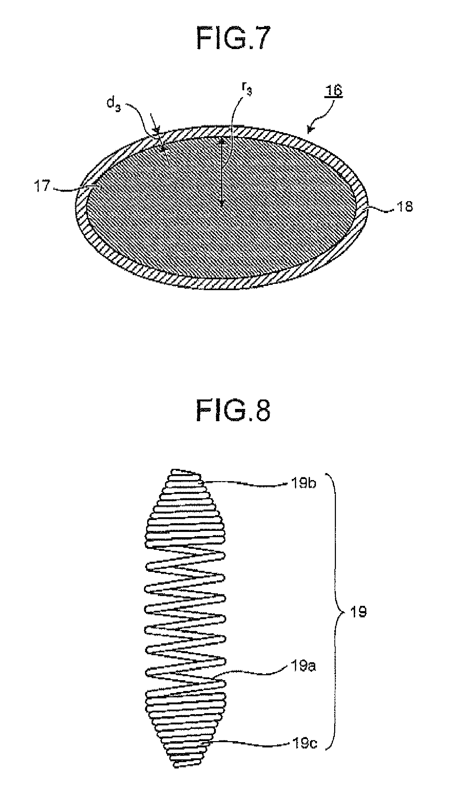

FIG. 7 is a transverse cross-sectional view illustrating a configuration of a spring wire rod according to a fourth modification of the embodiment. A spring wire rod 16 as illustrated in FIG. 7 has a wire core 17 and a coating member 18. The core 17 is made of a material that is the same as that of the core 2. The coating member 18 is made of a material that is the same as that of the coating member 3 and coats an outer circumference of the core 17. The spring wire rod 16 has a transverse cross section having an elliptical shape. A thickness d₃ of the coating member 18 is smaller than a minimum value r₃ of a distance between the center of gravity of the transverse cross section of the core 17 and the outer edge thereof.

As is also obvious from FIG. 5 to FIG. 7, in the embodiment, spring wire rods having various transverse cross-sectional shapes can be realized.

FIG. 8 is a view illustrating a configuration of a connection terminal as another application example of the spring wire rod 1 according to the embodiment. A connection terminal 19 as illustrated in FIG. 8 includes a coil spring portion 19a, and a pair of electrode pin portions 19b, 19c. The coil spring portion 19a is formed by winding the spring wire rod 1 at a constant pitch so as to be formed into a cylindrical shape. The pair of electrode pin portions 19b, 19c are formed by tightly-winding the spring wire rod 1 so as to be formed into a tapered form from both ends of the coil spring portion 19a. The connection terminal 19 having such a configuration can be also applied as a contact probe. It is to be noted that the pitch of the coil spring portion may be changed in the mid.

As application examples of the spring wire rod 1, a wire-type probe, a tensile coil spring, a torsion spring, and the like can be exemplified in addition to the above-mentioned example.

Hereinbefore, a mode for carrying out the invention has been described. However, the invention is not limited to the above-mentioned embodiment. That is to say, the invention may encompass various embodiments that are not described in the specification. Furthermore, various changes in design and the like can be made in a range without departing from a technical spirit specified by a scope of the invention.

### Industrial Applicability

The invention is useful as an elastic member, which a contact probe for testing electric characteristic of a semiconductor package and the like has, and is also useful as an electric contact member of an electric circuit. Reference Signs List

1, 8, 10, 13, 16 SPRING WIRE ROD
2, 11, 14, 17 CORE
3, 12, 15, 18 COATING MEMBER
4 PROBE UNIT
5 CONTACT PROBE
6 PROBE HOLDER
6h HOLDING HOLE
7 BASE MEMBER
9 PLATEED COATING
19 CONNECTION TERMINAL
19a COIL SPRING PORTION
19b, 19c ELECTRODE PIN PORTION
51 FIRST PLUNGER
51a, 52a FRONT END PORTION
51b, 52b FLANGE PORTION
51c, 52c BOSS PORTION
51d, 52d BASE END PORTION
52 SECOND PLUNGER
53 COMPRESSION COIL SPRING
61 FIRST SUBSTRATE
61a, 62a BASE MATERIAL
61b, 62b INSULATING COATING
62 SECOND SUBSTRATE
100 SEMICONDUCTOR PACKAGE
200 WIRING SUBSTRATE
611, 621 HOLE
611a, 621a SMALL DIAMETER HOLE
611b, 621b LARGE DIAMETER HOLE

## Claims

1. A spring wire rod comprising:
a wire core that is made of a conductive material having an electrical resistivity of equal to or lower than 5.00 × 10⁻⁸ Ω•m; and
a coating member that is made of a spring material having a longitudinal elastic modulus of equal to or higher than 1.00 × 10⁴ kgf/mm² and coats an outer circumference of the core.

2. The spring wire rod according to claim 1,
wherein a coating thickness of the coating member is smaller than a minimum value of a distance between a center of gravity of a transverse cross section of the core and an outer sedge of the transverse cross section.

3. The spring wire rod according to claim 1 or 2, further comprising a plated coating that coats an outer circumference of the coating merger.

4. A contact probe comprising:
a first plunger and a second plunger each of which has an axisymmetric shape and is made of a conductive material; and
a compression coil spring of which both ends in a lengthwise direction are press fitted onto respective ends of the first plunger and the second plunger, the respective ends being opposed to each other, the compression coil spring being extensible in the lengthwise direction,
wherein the compression coil spring is formed by winding the spring wire rod according to any one of claims 1 to 3 at a predetermined pitch.

5. A probe unit comprising:
a plurality of contact probes each of which has
a first plunger and a second plunger each of which has an axisymmetric shape and is made of a conductive material, and
a compression coil spring of which both ends in a lengthwise direction are press fitted onto respective ends of the first plunger and the second plunger, the respective ends being opposed to each other, the compression coil spring being extensible in the lengthwise direction; and
a plate-like probe holder having a plurality of holding holes that hold the contact probes such that the contact probes are extensible in a state where both ends of each contact probe are exposed from opposite plate faces,
wherein each compression coil spring is formed by winding the spring wire rod according to any one of claims 1 to 3 at a predetermined pitch.

6. The probe unit according to claim 5,
wherein the probe holder includes a base material that is made of a conductive material and an insulating coating that coats a surface of the base material.
